Europäisches Patentamt

European Patent Office

Office européen des brevets

(11) Veröffentlichungsnummer: **0 261 451**
**A1**

(12) **EUROPÄISCHE PATENTANMELDUNG**

(21) Anmeldenummer: 87112683.5

(51) Int. Cl.⁴: **G01D 5/243**

(22) Anmeldetag: 31.08.87

(30) Priorität: 02.09.86 DE 3629829

(43) Veröffentlichungstag der Anmeldung:
30.03.88 Patentblatt 88/13

(84) Benannte Vertragsstaaten:
CH DE FR GB LI

(71) Anmelder: Siemens Aktiengesellschaft Berlin
und München
Wittelsbacherplatz 2
D-8000 München 2(DE)

(72) Erfinder: Lippl, Friedrich, Dipl.-Ing.
Münchener Weg 3b
D-8131 Erling-Andechs(DE)

(54) **Frequenzverdopplungsschaltung für phasenverschobene, inkrementale Pulse eines Winkelschrittgebers.**

(57) Die Erfindung betrifft eine Frequenzverdopplungsschaltung für die von einem Winkelschrittgeber abgegebenen Sinus-und Kosinus-Signale. Erfinsungsgmeäß sind vier Komparatoren vorgesehen, wobei das Sinus-Signal an den nichtinvertierenden Eingängen des ersten und des zweiten Komparators anliegt, das invertierte Sinus-Signal am invertierenden Eingang des ersten Komparators und am nichtinvertierenden Eingang des vierten Komparators anliegt, das Kosinus-Signal am nichtinvertierenden Eingang des dritten Komparators anliegt, und das invertierende Kosinus-Signal an den ivnertierenden Eingängen des zweiten bis vierten Komparators anliegt. Weiter sind zwei XOR-Gatter vorgesehen, wobei die Ausgänge des ersten und dritten Komparators an den Eingängen des ersten XOR-Gatters und die Ausgänge des zweiten und vierten Komparators an den Eingängen des zweiten XOR-Gatters anliegen.

FIG 1

EP 0 261 451 A1

# Frequenzverdopplungsschaltung für phasenverschobene, inkrementale Pulse eines Winkelschrittgebers

Die Erfindung betrifft eine Frequenzverdopplungsschaltung gemäß dem Oberbegriff des Patentanspruchs.

In der Druckschrift "Ein neuer optoelektronischer Winkelschrittgeber für Steuerungs-und Regelaufgaben" aus "Bauteilereport" 16 (1978), Heft 1, Seite 1-5, ist die grundsätzliche Wirkungsweise eines Winkelschrittgebers beschrieben. An einem solchen Winkelschrittgeber sind zwei um 90° phasenverschobene sinus-bzw. kosinusförmige Signale abgreifbar. Diese werden durch das optische Abtasten von einer mit Löchern versehenen sogenannten Impulsscheibe erzeugt. Das Auflösungsvermögen eines solchen Winkelschrittgebers ist von der Anzahl der Striche bzw. Löcher auf der Impulsscheibe abhängig.

Als Maßnahme zur Erhöhung des Auflösungsvermögens wird dort folgendes vorgeschlagen. Das Sinus-und das Kosinus-Signal werden jeweils in ein Rechtecksignal umgeformt. Diese beiden Pulse und die zu ihnen komplementären Pulse durchlaufen vier monostabile Multivibratoren, die jede abfallende Flanke eines der Pulse in einen Impuls definierter Länge umwandeln. Es entsteht dann eine Serie von Impulsen gleicher Impulsdauer. Diese Anordnung liefert aber nicht bei jeder Drehgeschwindigkeit des Winkelschrittgebers ein Ausgangssignal mit einem 1 zu 1 Tastverhältnis.

Es ist weiter möglich, den Durchmesser der Impulsscheiben zu vergrößern, um die Anzahl der Markierungen zu erhöhen. Diese Maßnahme erhöht aber den Platzbedarf und vergrößert die Kosten.

Der Erfindung liegt die Aufgabe zugrunde, das Auflösungsvermögen bei einem Winkelschrittgeber zu erhöhen, wobei die Ausgangspulse ein 1 zu 1 Tastverhältnis aufweisen.

Diese Aufgabe wird erfindungsgemäß durch die im Patentanspruch angegebenen Merkmale gelöst.

In vorteilhafter Weise gibt die erfindungsgemäße Frequenzverdopplungsschaltung über ihre XOR-Gatter zwei um 90° phasenverschobene Ausgangspulse mit einem 1:1 Tastverhältnis ab.

Im folgenden wird die Erfindung anhand eines in der Zeichnung dargestellten Ausführungsbeispieles erläutert. Dabei zeigen

Fig. 1 die sinusförmigen Ausgangssignale des Winkelschrittgebers und

Fig. 2 die erfindungsgemäße Frequenzverdopplungsschaltung.

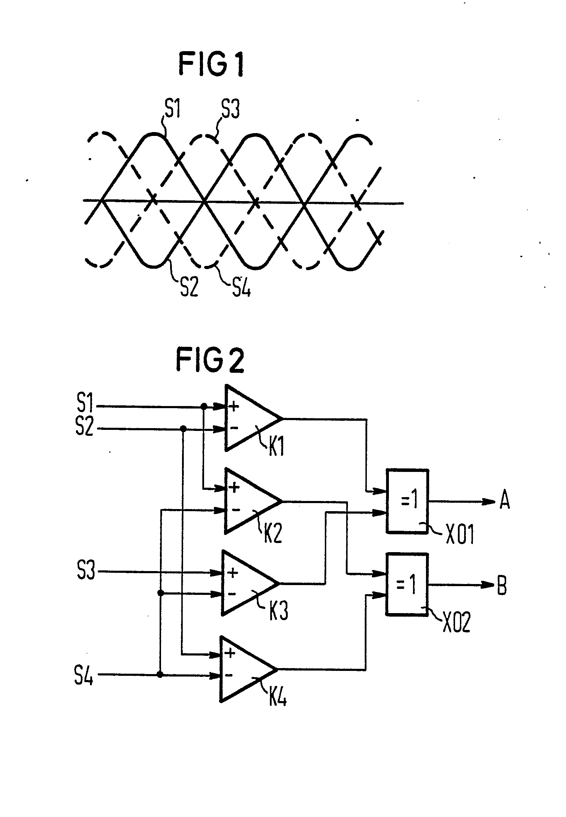

In Fig. 1 sind die sinus-bzw. kosinusähnlichen Ausgangssignale eines an sich bekannten Winkelschrittgebers dargestellt. Dies sind im einzelnen ein Sinus-Signal S1, das dazu invertierte Sinus-Signal S2, das Kosinus-Signal S3, und das dazu invertierte Kosinus-Signal S4. Die SinusSignale S1, S2 sind gegenüber den mit unterbrochenen Linien gezeichneten Kosinus-Signalen S3, S4 jeweils um 90° phasenversetzt.

Die erfindungsgemäße Frequenzverdopplungsschaltung besteht aus vier Komparatoren K1-K4, und zwei XOR-Gattern XO1, XO2. Das Sinus-Signal S1 liegt an den nicht invertierenden Eingängen des ersten und des zweiten Komparators K1, K2 an. Das invertierte Sinus-Signal S2 liegt am invertierenden Eingang des ersten Komparators K1 und am nichtinvertierenden Eingang des vierten Komparators K4 an. Das Kosinus-Signal S3 liegt am nichtinvertierenden Eingang des dritten Komparators K3 an, und das invertierte Kosinus-Signal S4 liegt an den invertierenden Eingänggen des zweiten, dritten und vierten Komparators K2-K4 an.

Vom ersten Komparator K1 wird daher eine logische 1 abgegeben, solange das Sinus-Signal S1 positiv gegenüber dem invertierten Sinus-Signal S2 ist. Vom zweiten Komparator K2 wird eine logische 1 abgegeben, solange das Sinus-Signal S1 positiv gegenüber dem invertierten Kosinus-Signal S4 ist. Vom dritten Komparator K3 wird eine logische 1 abgegeben, solange das Kosinus Signal S3 positiv gegenüber dem invertierten Kosinus-Signal S4 ist. Und schließlich wird vom vierten Komparator K4 eine logische 1 abgegeben, solange das invertierte Sinus-Signal S2 positiv gegenüber dem invertierten Kosinus-Signal S4 ist. Andernfalls wird von den Komparatoren K1-K4 eine logische Null abgegeben.

An den Eingängen des ersten XOR-Gatters XO1 sind die Ausgänge des ersten und des dritten Komparators K1, K3 angeschaltet. An den Eingängen des zweiten XOR-Gatters XO2 sind die Ausgänge des zweiten und des vierten Komparators K2, K4 angeschaltet. Von den beiden XOR-Gattern XO1, XO2 werden zwei um 90° gegeneinander phasenverschobene Ausgangspulse A, B abgegeben.

Diese Ausgangspulse A, B weisen die doppelte Frequenz auf wie die Sinus-bzw. Kosinus-Signale S1-S4 bzw. die aus ihnen formbaren Rechtecksignale. Weiter weisen die Ausgangspulse A, B ein 1-zu-1-Tastverhältnis auf, so daß übliche nachgeschaltete Auswerteschaltungen ohne Änderung anwendbar sind. Zudem lassen sich ohne Änderung vorhandene Winkelschrittgeber und Glasmaßstäbe bzw. Impulsscheiben verwenden, sofern sie ein sinusähnliches Signal abgeben.

## Ansprüche

Frequenzverdopplungsschaltung für von einem Winkelschrittgeber abgegebene Sinus-und Kosinus-Signale (S1, S3) bzw. die dazu invertierten Sinus- und Kosinus-Signale (S2, S4),

**gekennzeichnet durch**

vier Komparatoren (K1-K4), wobei das Sinus-Signal (S1) an den nichtinvertierenden Eingängen des ersten und des zweiten Komparators (K1, K2) anliegt, das invertierte Sinus-Signal (S2) am invertierenden Eingang des ersten Komparators (K1) und am nichtinvertierenden Eingang des vierten Komparators (K4) anliegt, das Kosinus-Signal (S3) am nichtinvertierenden Eingang des dritten Komparators (K3) anliegt, und das invertierte KosinusSignal (S4) an den invertierenden Eingängen des zweiten bis vierten Komparators (K2-K4) anliegt, und durch zwei XOR-Gatter (XO1, XO2), wobei die Ausgänge des ersten und dritten Komparators (K1, K3) an den Eingängen des ersten XOR-Gatters (XO1), und die Ausgänge des zweiten und vierten Komparators (K2, K4) an den Eingängen des zweiten XOR-Gatters (XO2) anliegen, und die an ihren Ausgängen zwei um 90° gegeneinander phasenverschobene Ausgangspulse (A, B) abgeben.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 009 339 (OLIVETTI) <br> * Figur 1A * <br> --- | 1 | G 01 D 5/243 |
| Y | PATENT ABSTRACTS OF JAPAN, Band 9, Nr. 129 (P-361) [1852], 5. Juni 1985; & JP-A-60 14 117 (MATSUSHITA DENKI SANGYO K.K.) 24-01-1985 <br> ----- | 1 | |
| | | | **RECHERCHIERTE SACHGEBIETE (Int. Cl.4)** <br><br> G 01 D |

Der vorliegende Recherchenbericht wurde für alle Patentansprüche erstellt

| Recherchenort | Abschlußdatum der Recherche | Prüfer |
|---|---|---|
| DEN HAAG | 04-12-1987 | HOORNAERT W. |

EPO FORM 1503 03.82 (P0403)